# EUROPEAN PATENT SPECIFICATION

(11) **EP 1 953 828 B1**
(45) Date of publication and mention of the grant of the patent: **11.05.2011**
(21) Application number: 07020333.6
(22) Date of filing: 17.10.2007
(51) Int. Cl.: H01L 31/0224, H01L 31/072, H01L 21/302, H01L 21/461

(54) **Inverted metamorphic solar cell with via for backside contacts**
Umgekehrte metamorphe Solarzelle mit Bohrung für Rückseitenverbindungen
Cellule solaire métamorphique inversée dotée de voies pour des contacts en face arrière

(30) Priority: 02.02.2007 US 701741
(43) Date of publication of application: 06.08.2008
(60) Divisional application: 10010911.5
(73) Proprietor: Emcore Solar Power, Inc., Albuquerque NM 87123 (US)
(72) Inventor: Sharps, Paul R., Albuquerque, NM 87112 (US)
(74) Representative: Wagner, Karl H.

(56) References cited:
- JP-A- 4 223 378
- JP-A- 63 211 773
- US-A- 5 510 272
- US-A1- 2006 231 130
- US-B1- 6 384 317
- US-B2- 6 951 819

## Description

### BACKGROUND OF THE INVENTION

### 1. Field of the Invention

The present invention relates to the field of solar cell semiconductor devices, and particularly to integrated semiconductor structures including a multijunction solar cell and a conducting via that allows both anode and cathode terminals to be placed on the back side of the cell.

### 2. Description of the Related Art

Photovoltaic cells, also called solar cells, are one of the most important new energy sources that have become available in the past several years. Considerable effort has gone into solar cell development. As a result, solar cells are currently being used in a number of commercial and consumer-oriented applications. While significant progress has been made in this area, the requirement for solar cells to meet the needs of more sophisticated applications has not kept pace with demand. Applications such as satellites used in data communications have dramatically increased the demand for solar cells with improved power and energy conversion characteristics.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as the payloads become more sophisticated, the design efficiency of solar cells, which act as the power conversion devices for the on-board power systems, become increasingly more important.

Solar cells are often fabricated in vertical, multijunction structures, and disposed in horizontal arrays, with the individual solar cell connected together in a series. The shape and structure of an array, as well as the number of cells it contains, are determined in part by the desired output voltage and current.

Inverted metamorphic solar cell structures such as described in U.S. Patent No. 6,951,819, the paper of M.W. Wanlass et al., Lattice Mismatched Approaches for High Performance, III - V Photovoltaic Energy Converters (Conference Proceedings of the 31st IEEE Photovoltaic Specialists Conference, Jan. 3-7, 2005, IEEE Press, 2005), and co-pending U.S. Patent Application Serial No. 11/445,793 filed June 2, 2006, of the present assignee, present an important development in future commercial solar cell products.

Since a solar cell is fabricated as a vertical, multijunction structure, one electrical contact is usually placed on the top surface of the cell, and the other contact on the bottom of the cell, to avoid internal interconnections which may affect reliability and cost. A variety of designs are also known in which both contacts are placed on one side of the cell, including as represented in U.S. Patent Application Serial No. 1,1/109,016 of the instant assignee.

Prior to the present invention, there has not been an inverted metamorphic solar cell with both anode and cathode contacts on the same side of the cell.

### SUMMARY OF THE INVENTION

Briefly, and in general terms, the present invention provides a method of manufacturing a solar cell by providing a first substrate; depositing on the substrate a sequence of layers of semiconductor material that forms at least one cell of a multijunction solar cell; etching a via from the top surface of the sequence of layers to the first substrate; providing a second substrate over the sequence of layers, and removing the first substrate.

More particularly the present invention is defined by a method according to claim 1.

### BRIEF DESCRIPTION OF THE DRAWINGS

These and other features and advantages of this invention will be better and more fully appreciated by reference to the following detailed description when considered in conjunction with the accompanying drawings, wherein:

FIG. 1 is an enlarged cross-sectional view of the solar cell structure according to the present invention at the end of the process steps of forming a multijunction solar cell on a first substrate;

FIG. 2 is a cross-sectional view of the structure of FIG. 1 with a via etched to the first substrate;

FIG. 3 is a cross-sectional view of the solar cell structure of FIG. 2 after the next process step according to the present invention including depositing a dielectric layer and a conductive layer in the via;

FIG. 4 is a cross-sectional view of the solar cell of FIG. 3 after the next process step according to the present invention in which a wafer carrier or surrogate second substrate is adhered to the "top" side of the solar cell structure;

FIG. 5 is a cross-sectional view of the solar cell of FIG. 4 after the next process step according to the present invention in which the first substrate is removed;

FIG. 6 is a cross-sectional view of the solar cell of FIG. 5 after the next process step according to the present invention in which a cap layer and metal contact layer is deposited on the structure;

FIG. 7 is a cross-sectional view of the solar cell of FIG. 6 after the next process step according to the present invention in which a cover glass is adhered to the solar cell structure on one side, and the surrogate second substrate removed on the other side; and

FIG. 8A and 8B are top and bottom plan views, respectively, of a wafer including the solar cell of the present invention.

### DESCRIPTION OF THE PREFERRED EMBODIMENT

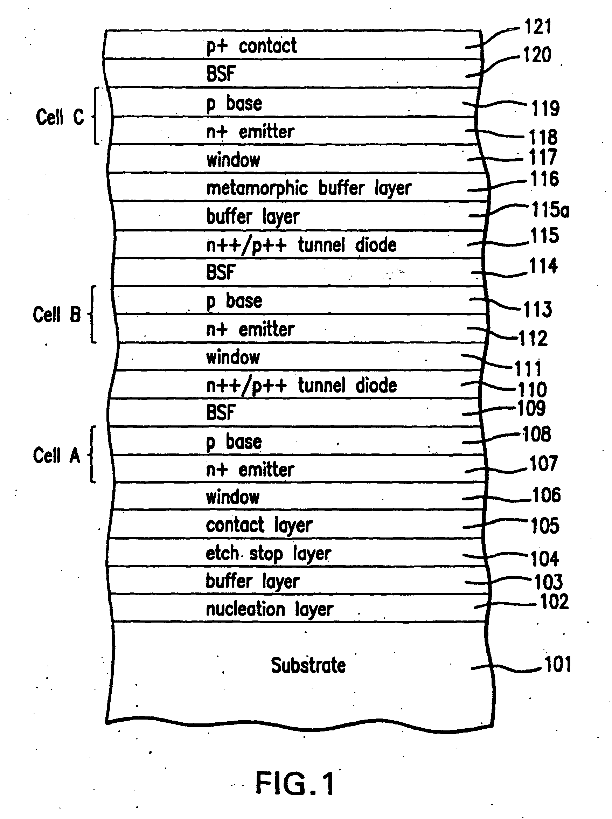

FIG. 1 depicts the multijunction solar cell according to the present invention after formation of the three subcells A, B and C on a substrate. More particularly, there is shown a first substrate 101, which may be either gallium arsenide (GaAs), germanium (Ge), or other suitable material. In the case of a Ge substrate, a nucleation layer 102 such as InGaP₂, is deposited on the substrate. On the substrate, or over the nucleation layer 102 in the case of a Ge substrate, a buffer layer 103 of InGaAs, and an etch stop layer 104 of InAlP₂ are further deposited. A contact layer 105 of InGaAs is then deposited on layer 104, and a window layer 106 of InAlP₂ is deposited on the contact layer. The subcell A, consisting of an n+ emitter layer 107 of InGaP₂ and a p-type base layer 108 of InGaP₂, is then deposited on the window layer 106.

Although the preferred embodiment utilizes the III - V semiconductor materials described above, the embodiment is only illustrative, and it should be noted that the multijunction solar cell structure could be formed by any suitable combination of group III to V elements listed in the periodic table subject to lattice constant and band gap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

In the preferred embodiment, the substrate 101 is gallium arsenide, the emitter layer 107 is composed of InGa(A1)P₂, and the base layer is composed of InGa(A1)P₂. The use of parenthesis in the formula is standard nomenclature to indicate that the amount of aluminum may vary from 0 to 30%.

On top of the base layer 108 is deposited a p+ type back surface field ("BSF") layer 109 of InGaAlP which is used to reduce recombination loss.

The BSF layer 109 drives minority carriers from the region near the baseBSF interface surface to minimize the effect of recombination loss. In other words, a BSF layer 109 reduces recombination loss at the backside of the solar subcell A and thereby reduces the recombination in the base.

On top of the BSF layer 109 is deposited a sequence of heavily doped p-type (such as AlGaAs) and n-type layers 110 (such as InGaP₂) which forms a tunnel diode which is a circuit element to connect cell A to cell B.

On top of the tunnel diode layers 110 a window layer 111 of n++ InAlP₂ is deposited. The window layer 111 used in the subcell B also operates to reduce the recombination loss. The window layer 111 also improves the passivation of the cell surface of the underlying junctions. It should be apparent to one skilled in the art that additional layer(s) may be added or deleted in the cell structure without departing from the scope of the present invention.

On top of the window layer 111 the layers of cell B are deposited: the emitter layer 112, and the p-type base layer 113. These layers are preferably composed of InGaP₂ for the emitter and either GaAs or In_{0.015}GaAs for the base, respectively, although any other suitable materials consistent with lattice constant and band gap requirements may be used as well.

On top of the cell B is deposited a BSF layer 114 of p+ type AlGaAs which performs the same function as the BSF layer 109. A p++/n++ tunnel diode 115 is deposited over the BSF layer 114 similar to the layers 110, again forming a circuit element to connect cell B to cell C. A buffer layer 115a, preferably InGaAs, is deposited over the tunnel diode 115, with a thickness of about 1.0 micron. A metamorphic buffer layer 116 is then deposited over the buffer layer 115a. The layer 116 is preferably a compositionally step-graded composition of InGaAlAs deposited as a series of layers with monotonically changing lattice constant that provides a transition in lattice constant from cell B to subcell C. The bandgap of layer 116 is 1.5 ev constant with a value slightly greater than the bandgap of the middle cell B.

In one embodiment, as suggested in the Wanlass et al. paper, the step grade contains nine compositionally graded steps with each step layer having a thickness of 0.25 micron. In the preferred embodiment, the interlayer is composed of InGaAlAs, with monotonically changing lattice constant.

On top of the metamorphic buffer layer 116 another n+ window layer 117 is deposited. The window layer 117 improves the passivation of the cell surface of the underlying junctions. Additional layers may be provided without departing from the scope of the present invention.

On top of the window layer 117 the layers of subcell C are deposited; the n-type emitter layer 118 and the p type base layer 119. In the preferred embodiment, the emitter layer is composed of GaInAs and the base layer is composed of GaInAs with about a 1.0 ev bandgap, although any other semiconductor materials with suitable lattice constant and band gap requirements may be used as well.

On top of the base layer 119 of subcell C a back surface field (BSF) layer 120, preferably composed of GaInAsP, is deposited.

Over or on top of the BSF layer 120 is deposited a p+ contact layer121, preferably of p+ type InGaAs.

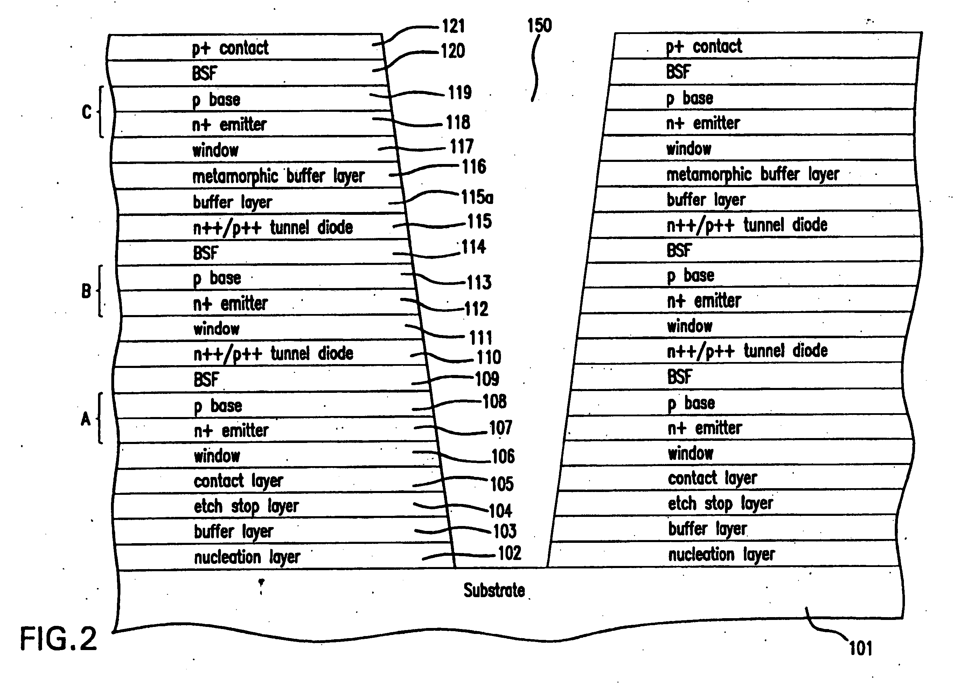

FIG. 2 is a cross-sectional view of the structure of FIG. 1 after the process step of a via 150 being etched from the top surface of the deposited layers 102 through 121 by dry or wet chemical processes to the substrate 101.

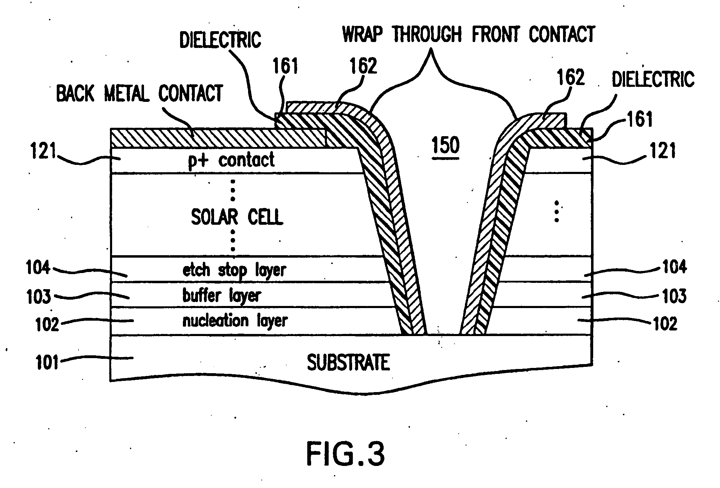

FIG. 3 is a cross-sectional view of the solar cell structure of FIG. 2 after the next sequence of process step according to the present invention including depositing a back metal layer over the p+ contact layer 121, and depositing a dielectric layer 161 in the interior of the via 150 and over a portion of the back metal contact layer. A conductive layer 162 is then deposited in the via 150 and over the dielectric layer 161. The layer 162 serves as a wrap through front contact for the solar cell.

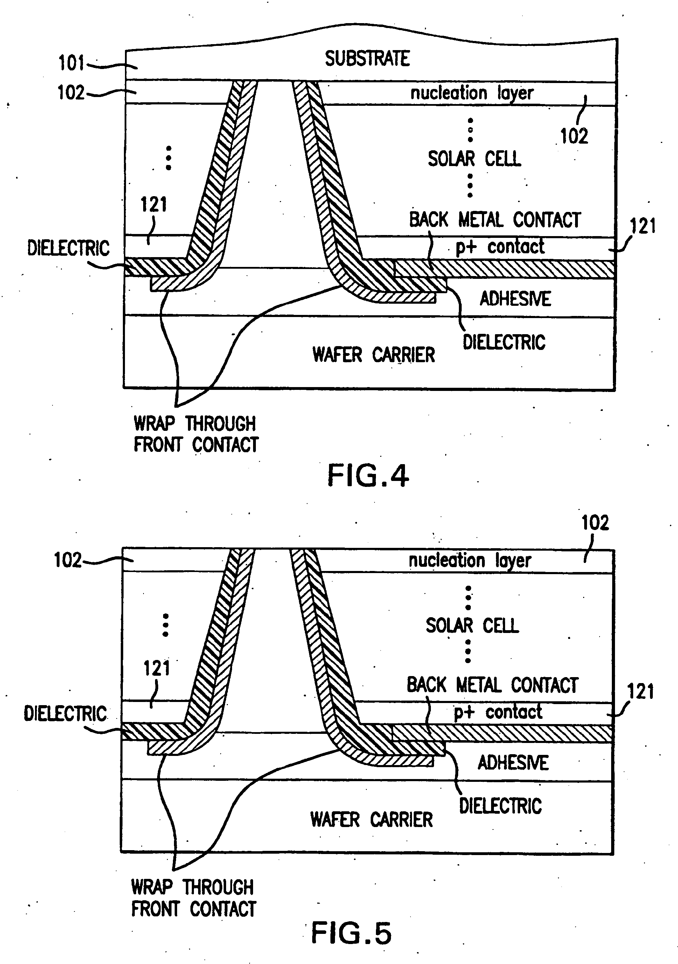

FIG. 4 is a cross-sectional view of the solar cell of FIG. 3 (how oriented with the substrate 101 at the top of the Figure) after the next process step according to the present invention. A wafer carrier or surrogate second substrate is adhered to the "top" side of the solar cell structure, which is now at the bottom of the Figure. In the preferred embodiment, the surrogate substrate is sapphire about 1000 microns in thickness, and is perforated with holes about 1 mm in diameter, spaced 4 mm apart, to aid in subsequent removal of the substrate.

FIG. 5 is a cross-sectional view of the solar cell of FIG. 4 after the next process step according to the present invention in which the first substrate101 is removed by a lapping or grinding process.

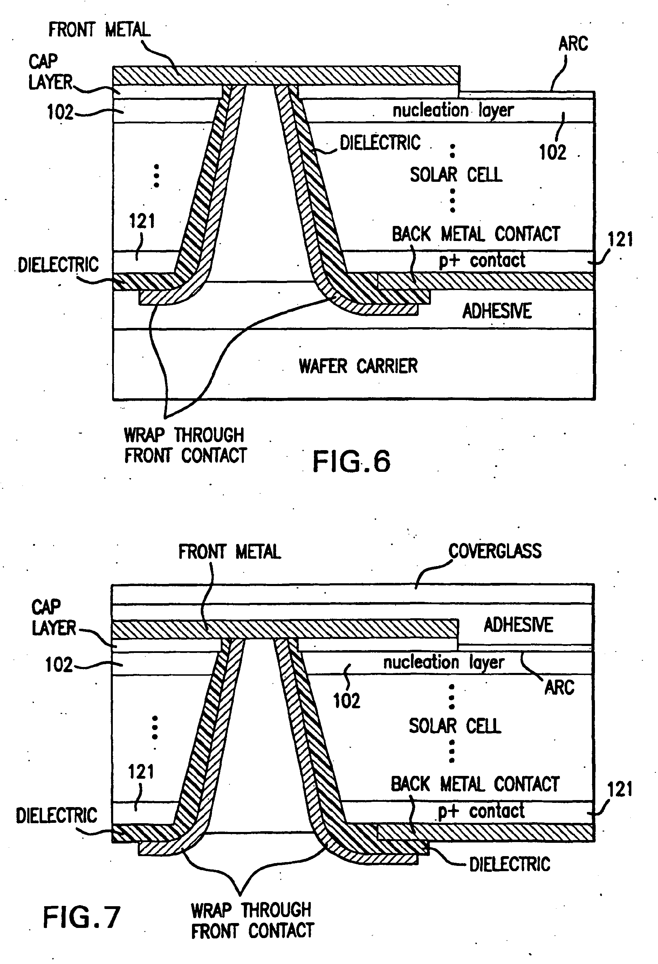

FIG. 6 is a cross-sectional view of the solar cell of FIG. 5 after the next process step according to the present invention in which a cap layer is deposited over a portion of the nucleation layer in the region of the via 150 and metal contact layer is deposited over the cap layer, making electrical contact with the metal layer 161 inside the via 150. An antireflective coating (ARC) layer is then applied over the surface of the nucleation layer.

FIG. 7 is a cross-sectional view of the solar cell of FIG. 6 after the next process step according to the present invention in which an adhesive is applied over the front metal layer and the ARC layer, and a cover glass is adhered to the solar cell structure. On the other side, the surrogate second substrate is then removed by dissolving the adhesive attaching it, or any other suitable technique.

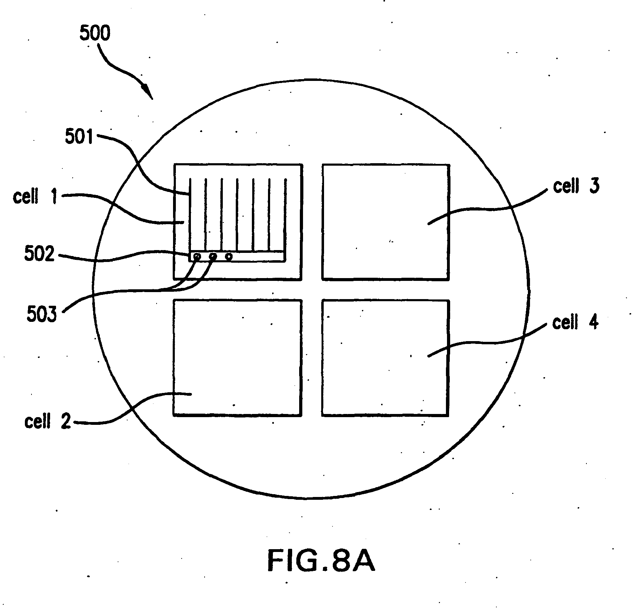

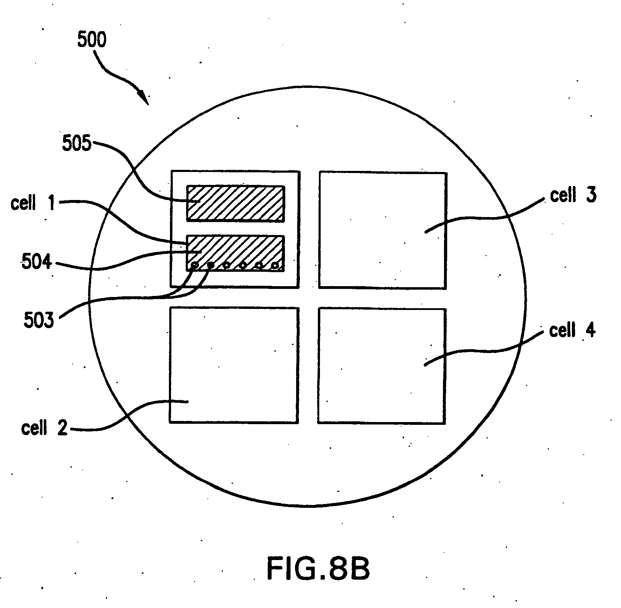

FIG. 8A and 8B are top and bottom plan views, respectively of a wafer including the solar cell of the present invention. In FIG. 8A, Cell 1 of each wafer is illustrated in greater detail with grid lines 501, a bus 502, and circular regions 503 in which a via 150 extends through the wafer such as shown in previous cross-sectional views.

FIG. 8B depicts the back side contact region 505 and a wrap through front contact region 504 with vias 503 corresponding to those shown in FIG. 8A.

## Claims

1. A method of manufacturing a multijunction solar cell comprising:
providing a first substrate (101);
depositing on said subsbrate (101) a sequence of layers (102-121) of semiconductor material that forms at least one cell of a multijunction solar dell;
etching a via (150) from the top surface of said sequence of layers (102-121) to said first substrate (101);
depositing a back metal contact layer over the last layer (121) of the sequence of layers;
depositing a layer of dielectric material (161) circumferentially around the inside surface of the via (150), and over a portion of the back metal contact layer;
depositing a conductive layer (162) over said layer of dielectric material (161) extending throughout the via (150);
adhering a second substrate over said top surface;
removing said first substate (101) exposing a front surface of the solar cell; depositing a front metal grid (501) on the front surface of the solar cell electrically connected to said conductive layer (162).

2. A method as defined in claim 1, further comprising depositing first and second electrode contact pads (front contact region 504; backside contact region 505) on the back surface of said solar cell, said first electrode contact pad (504) being electrically connected to said conductive layer (162).

3. A method as defined in claim 1, wherein said step of depositing a sequence of layers of semiconductor material (102-121) comprises forming a first solar subcell (cell A) on said substrate having a first band gap; forming a second solar subcell (cell B) over said first subcell having a second band gap smaller than said first band gap; forming a grading interlayer (114) over said second subcell having a third band gap larger than said second band gap; forming a third solar subcell (cell C) having a fourth band gap smaller than said second band gap such that said third subcell (cell C) is lattice mis-matched with respect to said second subcell (cell B).

4. A method of manufacturing a solar cell as defined in claim 1, wherein said first substrate (101) is composed of GaAs.

5. A method of manufacturing a solar cell as defined in claim 3, wherein said first solar subcell (cell A) is composed of an InGa(A1)P emitter region and an InGa(A1)P base region, and said second solar subcell (cell B) is composed of an InGaP₂ emitter region and an In_{0.015}GaAs base region.

6. A method of manufacturing a solar cell as defined in claim 3, wherein the grading interlayer (113) is composed of a plurality of layers of InGaAlAs with monotonically increasing lattice constant.

## Patentansprüche

1. Ein Verfahren zur Herstellung einer Multijunction-Solarzelle, wobei Folgendes vorgesehen ist:
Vorsehen eines ersten Substrats (101);
Abscheiden einer Sequenz oder Folge von Schichten (102 - 121) auf dem Substrat (101), und zwar von Schichten (102 - 121) aus Halbleitermaterial, das mindestens eine Zelle einer Multijunction-Solarzelle bildet;
Ätzen einer Durchkontaktierung bzw. Via (150) von der oberen Oberfläche der Folge von Schichten (102-121) zu dem ersten Substrat (101);
Abscheiden einer hinteren Metallkontaktschicht über der letzten Schicht (121) der Folge von Schichten,
Abscheiden einer Schicht aus dielektrischem Material (161) umfangsmäßig um die Innenseitenoberfläche der Durchkontaktierung und über einem Teil der hinteren Metallkontaktschicht ;
Abscheiden einer leitenden Schicht (162) über der erwähnten Schicht aus dielektrischem Material (161) und sich über die ganze Durchkontaktierung (150) erstreckend;
Anhaften eines zweiten Substrats über der erwähnten oberen Oberfläche;
Entfernen des ersten Substrats (101) unter Freilegung einer vorderen Oberfläche der Solarzelle;
Abscheiden eines vorderen Metallgitters (501) auf der vorderen Oberfläche der Solarzelle, und zwar elektrisch verbunden mit der leitenden Schicht (162).

2. Verfahren nach Anspruch 1, wobei ferner Folgendes vorgesehen ist:
Abscheiden erster und zweiter Elektrodenkontaktflächen (Vorderkontaktbereich 504; Rückseitenkontaktbereich 505) auf der hinteren Oberfläche der Solarzelle, wobei die erste Elektrodenkontaktfläche (504) elektrisch mit der leitenden Schicht (162) verbunden ist.

3. Verfahren nach Anspruch 1, wobei der Schritt des Abscheidens einer Folge von Schichten aus Halbleitermaterial (102 - 121) Folgendes aufweist:
Bilden einer ersten solaren Subzelle (Zelle A) auf dem erwähnten Substrat mit einem ersten Bandabstand;
Formen einer zweiten solaren Subzelle (Zelle B) über der ersten Subzelle mit einem zweiten Bandabstand, der kleiner ist als der erste Bandabstand;
Formen einer Gradierzwischenschicht (Schicht mit monoton sich änderndem Parameter) (114) über der zweiten Subzelle mit einem dritten Bandabstand, der größer ist als der zweite Bandabstand;
Formen einer dritten solaren Subzelle (Zelle C) mit einem vierten Bandabstand kleiner als dem erwähnten zweiten Bandabstand derart, dass die dritte Subzelle (Zelle C) gitterfehlangepasst bezüglich der zweiten Subzelle (Zelle B) ist.

4. Verfahren zur Herstellung einer Solarzelle nach Anspruch 1, wobei das erste Substrat (101) aus GaAs aufgebaut ist.

5. Verfahren zur Herstellung einer Solarzelle nach Anspruch 3, wobei die erste solare Subzelle (Zelle A) aufgebaut ist aus einem InGa(A1)P Emitterbereich und einem InGa(A1)P Basisbereich, und wobei ferner die zweite solare Subzelle (Zelle B) aufgebaut ist aus einem InGaP₂ im Emitterbereich und einem In_{0,015}GaAs Basisbereich.

6. Verfahren zur Herstellung einer Solarzelle nach Anspruch 3, wobei die Gradierzwischenschicht (113) aufgebaut ist aus einer Vielzahl von Schichten aus InGaAlAs mit monoton ansteigenden Gitterkonstanten.

## Revendications

1. Procédé de fabrication d'une cellule solaire multijonction consistant à :
fournir un premier substrat (101) ;
déposer sur ledit substrat (101) une séquence de couches (102-121) de matériau semiconducteur qui forme au moins une cellule d'une cellule solaire multijonction ;
graver une traversée (150) depuis la surface supérieure de ladite séquence de couches (102-121) jusqu'audit premier substrat (101) ;
déposer une couche de contact métallique arrière sur la dernière couche (121) de la séquence de couches ;
déposer circonférentiellement une couche de matériau diélectrique (161) sur le pourtour de la surface intérieure de la traversée (150) et sur une partie de la couche de contact métallique arrière ;
déposer une couche conductrice (162) sur ladite couche de matériau diélectrique (161) s'étendant dans la totalité de la traversée (150) ;
faire adhérer un second substrat sur ladite surface supérieure ;
enlever ledit premier substrat (101) en exposant une surface avant de la cellule solaire ;
déposer une grille métallique avant (501) sur la surface avant de la cellule solaire électriquement connectée à ladite couche conductrice (162).

2. Procédé selon la revendication 1, consistant en outre à déposer des première et seconde plages de contact d'électrodes (région de contact avant 504 ; région de contact de face arrière 505) sur la surface arrière de ladite cellule solaire, ladite première plage de contact d'électrodes (504) étant électriquement connectée à ladite couche conductrice (162).

3. Procédé selon la revendication 1, dans lequel ladite étape de dépôt d'une séquence de couches de matériau semiconducteur (102-121) consiste à former une première sous-cellule solaire (cellule A) sur ledit substrat ayant une première bande interdite ; former une seconde sous-cellule solaire (cellule B) sur ladite première sous-cellule ayant une seconde bande interdite inférieure à ladite première bande interdite ; former une intercouche de gradation (114) sur ladite seconde sous-cellule ayant une troisième bande interdite supérieure à ladite seconde bande interdite ; former une troisième sous-cellule solaire (cellule C) ayant une quatrième bande interdite inférieure à ladite seconde bande interdite de façon que ladite troisième sous-cellule (cellule C) présente une désadaptation de réseau par rapport à ladite seconde sous-cellule (cellule B).

4. Procédé de fabrication d'une cellule solaire selon la revendication 1, dans lequel ledit premier substrat (101) est composé de GaAs.

5. Procédé de fabrication d'une cellule solaire selon la revendication 3, dans lequel ladite première sous-cellule solaire (cellule A) est composée d'une région d'émetteur d'InGa(A1)P et d'une région de base d'InGa(A1)P, et ladite seconde sous-cellule solaire (cellule B) est composée d'une région d'émetteur d'InGaP₂ et d'une région de base d'In_{0,015}GaAs.

6. Procédé de fabrication d'une cellule solaire selon la revendication 3, dans lequel l'intercouche de gradation (113) est composée d'une pluralité de couches d'InGaAlAs ayant une constante de réseau croissant de manière monotone.
